# EUROPEAN PATENT APPLICATION

(11) **EP 4 614 215 A1**
(43) Date of publication of application: **10.09.2025**
(21) Application number: 24196258.8
(22) Date of filing: 23.08.2024
(51) Int. Cl.: G02F 1/01, G02B 6/126, G02B 6/27, G02B 27/28, H04B 10/61

(54) **MULTI-POLARIZATION OPTICAL DEVICE**

(30) Priority: 08.03.2024 US 202418599506
(71) Applicant: II-VI Delaware, Inc., Wilmington, DE 19890 (US)
(72) Inventor: SMOLORZ, Sylvia, Wilmington, 19890 (US)
(74) Representative: Schmidt, Christian

(57) **Abstract**

An optical device includes a first chip and a second chip. The first chip includes a first polarized signal optical port, a second polarized signal optical port, and one or more optical elements coupled to the first polarized signal optical port and the second polarized signal optical port. The second chip includes a first polarized signal optical port coupled to the first polarized signal optical port of the first chip, a second polarized signal optical port coupled to the second polarized signal optical port of the first chip, a multi-polarized signal optical port, and a polarization rotating and combining element that couples the first polarized signal optical port and the second polarized optical port to the multi-polarized signal optical port. The first chip comprises a first semiconductor chip material. The second chip comprises a second semiconductor chip material that is different than the first semiconductor chip material.

## Description

### TECHNICAL FIELD

Aspects of the present disclosure are related to optical communication systems, optical transmitters, and optical transmitters.

### BACKGROUND

An optical transmitter may transmit data using signals of multiple polarizations. In this manner, the optical transmitter may better utilize bandwidth of an optical fiber used to guide the transmitted signals. For example, an optical transmitter may transmit a dual polarization signal that includes first data modulated on a transverse-electric (TE) polarized signal and second data modulated on a transverse-magnetic (TM) polarized signal. To this end, such an optical transmitter may modulate the first data on a first TE polarized signal and may modulate the second data on a second TE polarized signal. The optical transmitter may rotate the modulated first TE polarized signals by 90° to obtain a modulated TM polarized signal. The optical transmitter may combine the modulated TM polarized signal with the modulated second TE polarized signal and inject the combined signal into the optical fiber. In this manner, the optical transmitter may transmit data over the optical fiber via a signal having multiple polarizations.

Generally, aspects of the optical transmitter (*e*.*g*., modulators, amplifiers, *etc*.) may be implemented via a semiconductor chip. However, discrete components (e.g., lens, waveplates, *etc*.) external to the semiconductor chip may provide aspects of the optical transmitter for which the semiconductor chip is ill-suited. For example, III-V semiconductor devices, such as Indium Phosphide (InP) devices, adequately confine an optical mode of a signal in a horizontal dimension. However, due to a lack of a native oxide, III-V semiconductor devices provide a weak vertical confinement of signals. Thus, TE polarized signals are well confined in a III-V semiconductor device, but the TM polarized signals are not. As such, III-V semiconductor devices are generally suitable for implementing modulators, amplifiers, and possibly other aspects of the optical transmitter, but provide a poor vehicle for guiding and manipulating TM polarized signals. As such, a single III-V semiconductor device or chip proves to be an impractical medium for realizing a multi-polarization optical transmitter.

### BRIEF SUMMARY OF THE DISCLOSURE

Shown in and/or described in connection with at least one of the figures, and set forth more completely in the claims, are optical devices and associated methods. In various embodiments, the optical device may include a first chip or semiconductor device such as a III-V semiconductor chip coupled to a second chip or semiconductor device such as a silicon photonic (SiP) chip. In various embodiments, the first chip may include a plurality of modulators that each modulate data upon a respective polarized signal. In particular, each of the modulated signals produced by the plurality of modulators may have a same polarization. The first chip may further include amplifiers that amplify the modulated signals prior to providing the modulated signals to the second chip. The second chip may rotate one or more the modulated signals received from the first chip and combine the modulated signals into a combined signal comprising modulated signals of different polarizations.

These and other advantages, aspects and novel features of the present disclosure, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1 depicts an optical communication system comprising an optical device and a fiber array per aspects of the present disclosure.
FIG. 2 depicts an optical communication system comprising an optical device and a fiber array per aspects of the present disclosure.
FIG. 3 depicts an optical communication system comprising an optical device and a fiber array per aspects of the present disclosure.
FIG. 4 depicts an optical communication system comprising an optical device and a fiber array per aspects of the present disclosure.
FIGS. 5A-5C depict an optical communication system comprising an optical device and a fiber array per aspects of the present disclosure.
FIG. 6 depicts an alignment device to aid aligning optical fibers of a fiber array with optical ports an optical device.
FIG. 7 depicts an alignment device to aid aligning optical fibers of a fiber array with optical ports an optical device.

### DESCRIPTION

The following discussion provides various examples of optical communications systems, optical transmitters, optical receivers, and associated methods. Such examples are non-limiting, and the scope of the appended claims should not be limited to the particular examples disclosed. In the following discussion, the terms "example" and "e.g." are non-limiting.

The figures illustrate a general manner of construction. Descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

In various embodiments, an optical communication system may include an optical transmitter configured to transmit a modulated signal having multiple polarizations and/or an optical receiver configured to receive a modulated signal having multiple polarizations. To this end, the optical transmitter may comprise a first chip and a second chip. The first chip may modulate data upon respective polarized signals and may amplify the modulated signals. The second chip may receive the modulated signals, rotate the polarization of one or more of the modulated signals, and combine the signals to obtain a modulated signal having multiple polarizations. The second chip may inject the combined signal into an optical fiber of a fiber array.

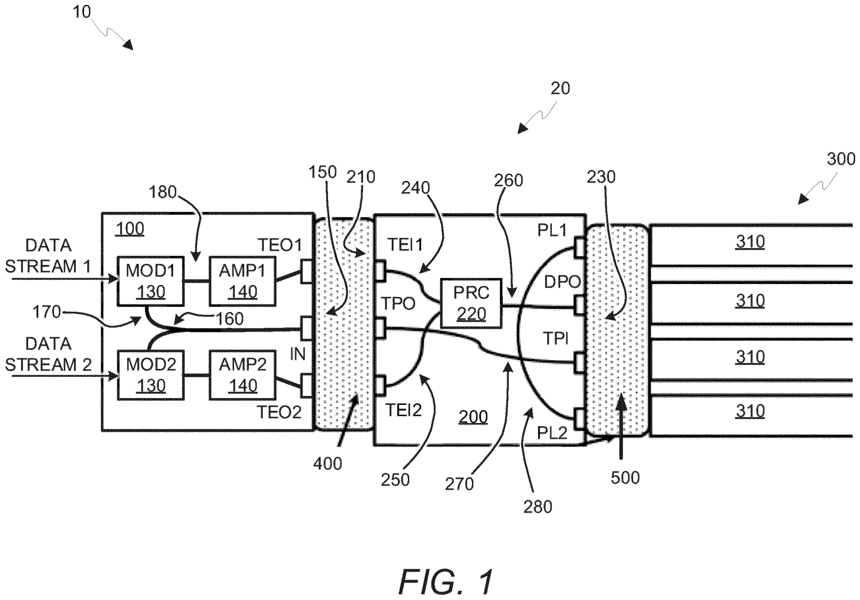

Referring now to FIG. 1, aspects of an optical communication system 10 are shown. In particular, FIG. 1 depicts an optical transmitter 20 and a fiber array 300 of the optical communication system 10. As shown, the optical transmitter 20 comprises a first chip 100 of a first semiconductor chip material and a second chip 200 of a second semiconductor chip material. In various embodiments, the first chip 100 comprises an Indium Phosphide (InP) chip and the second chip 200 comprises a silicon photonic chip (SiP) having a silicon-on-insulator construction. Although InP is used as an example semiconductor chip material for the first chip 100 of the present disclosure, the same principles apply to other III-V semiconductor chip materials. As such, the first chip 100 may utilize other III-V semiconductor chip materials such as Gallium Arsenide (GaAs).

The first chip 100 may include one or more optical elements such as modulators 130 and amplifiers 140 coupled to optical ports 150 (e.g., IN, TEO1, TEO2). In general, the first chip 100 may include a signal input port IN that receives an unmodulated laser light or an unmodulated signal. The first chip 100 may further include splitters 160, waveguides 170, *etc.* that split the unmodulated signal and guide the unmodulated signal to each modulator 130. The first chip 100 may also include modulated signal waveguides 180 that guide modulated signals from the modulators 130 to respective optical ports TEO1, TEO2. To this end, each modulator 130 may produce a modulated signal by modulating its received unmodulated signal based on a respective data stream.

In some embodiments, the first chip 100 may include processing circuity and/or other data sources that generate and provide each modulator 130 with a respective data stream. In other embodiments, the data streams may be generated off chip and received from one or more external data sources via one or more inputs of the first chip 100.

In some embodiments, the modulated signal waveguides 180 may respectively guide the modulated signals to a first modulated signal port TEO1 and a second modulated signal port TEO2. In other embodiments, the modulated signal waveguides 180 may guide the modulated signals through amplifiers 140 that amplify the modulated signals prior to being guided to their respective modulated signal ports TEO1, TEO2.

In various embodiments, a laser or other signal source may provide the signal input port IN of the first chip 100 with a unmodulated signal having a first polarization that is suitable for the semiconductor chip material of the first chip 100. As noted above, InP chips are well-suited for confining and processing TE polarized signals. Accordingly, in an example InP embodiment of the first chip 100, the laser or other signal source may provide the signal input port IN with an unmodulated, TE polarized signal. Moreover, the modulators 130, amplifiers 140, splitters 160, and waveguides 170, 180 of the first chip 100 may maintain the TE polarization of the signal. As such, the first modulated signal may exit the first modulated signal port TEO1 with a TE polarization and the second modulated signal may likewise exit the second modulated signal port TEO2 with a TE polarization.

The second chip 200 may include first optical ports 210 (e.g., TEI1, TEI2, TPO), a polarization rotation and combining (PRC) element 220, and second optical ports 230 (e.g., PL1, PL2, TPI, DPO). In general, the first optical ports 210 are coupled to the optical ports 150 of the first chip 100 and the second optical ports 230 are coupled to the fiber array 300.

As shown, a first modulated signal waveguide 240 may couple a first modulated signal port TEI1 to the PRC element 220 and a second signal waveguide 250 may couple a second modulated signal port TEI2 to the PRC element 220. Moreover, the first modulated signal port TEI1 of the second chip 200 may be coupled to the first modulated signal port TEO1 of the first chip 100. As such, the first modulated signal waveguide 240 may guide the first modulated signal exiting the first chip 100 to the PRC element 220 of the second chip 200. Similarly, the second modulated signal port TEI2 of the second chip 200 may be coupled to the second modulated signal port TEO2 of the first chip 100. As such, the second modulated signal waveguide 250 may guide the second modulated signal exiting the first chip 100 to the PRC element 220.

The second chip 200 may further include a multi-polarized signal waveguide 260 that couples the PRC element 220 to a multi-polarized or dual polarized signal port DPO. The second chip 200 may also include a pass-through waveguide 270 that couples an unmodulated signal port TPI to an unmodulated signal port TPO of the second chip 200. As shown, the unmodulated signal port TPO may be coupled to the signal input port IN of the first chip 100. As such, an unmodulated signal produced by a laser or other signal source may be provided to the unmodulated signal port TPI of the second chip 200 via a fiber of the fiber array 300 and the pass-through waveguide 270 may guide the unmodulated signal through the second chip 200 and to the first chip 100 via the unmodulated signal port TPO.

As further shown, the second chip 200 may include a passive loop waveguide 280 that couples a first passive loop port PL1 to a second passive loop port PL2. As explained in more detail below, the passive loop ports PL1, PL2 and the passive loop waveguide 280 may aid in properly aligning fibers 310 of the fiber array 300 with the optical ports 230.

Due to the above waveguides, the first modulated signal and the second modulated signal of the first chip 100 are guided to the PRC element 220. The PRC element 220 may rotate the polarization of one of the received modulated signals (e.g., the first modulated signal) and may combine the rotated signal and the other modulated signal (e.g., the second modulated signal) into a combined modulated signal having multiple polarizations. The multi-polarized signal waveguide 260 may guide the combined modulated signal from the PRC element 220 to the multi-polarized signal port DPO. In various embodiments, the first chip 100 may emit the first modulated signal and the second modulated signal with a TE polarization. The PRC element 220 may rotate the TE polarization of one of the signals by 90°, thus resulting in the rotated signal having a TM polarization. As such, the PRC element 220 may provide a combined modulated signal having a dual polarization comprising data carried by a TE polarized signal and data carried by a TM polarized signal of the combined modulated signal.

Unlike III-V semiconductor chip materials, silicon is well-suited for both TE and TM signals. In particular, silicon-on-insulator waveguides provide very good confinement for both TE and TM signals. Moreover, silicon chip structures may implement polarization rotation and signal combination functions in a very compact footprint. Thus, the first chip 100 and the second chip 200 of the optical communication system 10 may leverage the strengths of their respective semiconductor chip materials. Namely, the optical communication system 10 may combine the strengths of InP or other III-VI materials (e.g., efficient modulation and amplification) with those of SiP (e.g., low loss waveguides, compact structures, and polarization handling).

As depicted, the optical ports 150 of the first chip 100 may be coupled to the first optical ports 210 of the second chip 200 via a first epoxy 400. Similarly, the second optical ports 230 of the second chip 200 may be coupled to optical fibers 310 of the fiber array 300 via a second epoxy 500. In some embodiments, facets of one or more of the optical ports 150, 210, 230 may be coated with an anti-reflective coating. The anti-reflective coating may have a refractive index that matches the refractive index of the epoxy 400, 500 engaging the facet of the respective optical port 150, 210, 230. In some embodiments, the index of refraction of the epoxy 400 and the epoxy 500 matches the index of refraction of the waveguide mode for the second chip 200. In such embodiments, the facets for the optical ports 210, 230 of second chip 200 may be uncoated and the facet for the optical ports 150 of the first chip 100 may be coated with an anti-reflection coating that matches the index of refraction of the epoxy 400. In some embodiments, the epoxy 500 on the fiber side of the second chip 200 may differ from the epoxy 400 on the first chip side of the second chip 200.

As noted above, the second chip 200 may include a passive loop waveguide 280 between the optical ports PL1, PL2, a pass-through waveguide 270 coupled to the optical port TPI, and a multi-polarized signal waveguide 260 coupled to the multi-polarized signal port DPO. Moreover, the optical ports PL1, PL2, TPI, DPO are coupled to respective optical fibers 310 of the fiber array 300. In various embodiments, the spacing between the optical fibers 310 of the fiber array 300 matches the spacing of the optical ports PL1, TP1, DPO, PL2 of the second chip 200. Similarly, the spacing of the optical ports TEI1, TEI2, TPO of the second chip 200 matches the spacing of the optical ports TEO1, TEO2, IN of the first chip 100.

To increase the tolerance to misalignment, the optical ports 150 of the first chip, and the optical ports 210, 230 of the second chip 200 may each include a spot size converter that expands the waveguide mode of the respective facet. In particular, the spot size converters for the fiber-facing optical ports 230 of the second chip may expand the optical mode of the optical ports 230 to match the fiber mode of the attached optical fibers 310. Similarly, the spot size converters for the first-chip-facing optical ports 210 may expand the optical mode to the optical mode of the optical ports 150 of the first chip 100. In various embodiments, the spot size converters for the first-chip-facing optical ports 210 may expand the optical mode less than the spot size converters for the fiber-facing optical ports 230.

To align the fiber array 300 to the optical ports 230, light may be injected into the optical fiber 310 corresponding to optical port PL1. The relative position of the second chip 200 to the fiber array 300 may then be adjusted to maximize a coupling of light applied to optical port PL1 to optical port PL2 via passive loop waveguide 280. The optical fiber 310 corresponding to optical port PL2 may be coupled to a photodetector or other sensor to monitor the coupling of the light through the passive loop waveguide 280. As noted above, the spacing of the optical ports 230 of the second chip 200 matches the spacing of the optical fibers 310 of the fiber array 300. Thus, proper alignment of the optical fibers 310 to the optical ports PL1, PL2 via the above alignment process ensures that the optical ports TP1, DPO are also appropriately aligned with corresponding optical fibers 310 of the fiber array 300. After proper alignment is achieved, the epoxy 500 may be applied in order to attach and maintain proper alignment between the fiber array 300 and the second chip 200.

After attaching the fiber array 300 to the second chip 200, the optical ports 150 of the first chip 100 may be aligned and coupled to the optical ports 210 of the second chip 200. Such alignment may be achieved actively based on light exiting the optical ports 150 or passively based on fiducials or through flip-chip bonding techniques. The residual gap between the first chip 100 and the second chip may then be filled with the epoxy 400.

The second chip 200 is described above and depicted in the figures as part of an optical transmitter 20. However, the second chip 200 may also be suitable for an optical receiver. In particular, the optical ports 230 of the second chip 200 may be used as input ports of an optical receiver. In such usage, the PRC element 220 may split the TM polarized signal from the TE polarized signal of an incoming dual polarization signal. The PRC element 220 may further rotate polarization of the TM polarized signal in order to provide two TE polarized signals at the optical ports 210. In such a receiver implementation, the pass through optical port TPI may be used to pass local oscillator light through the second chip 200 to one or more balanced receiver pairs of the first chip 100 which are configured for coherent reception using the received local oscillator signal.

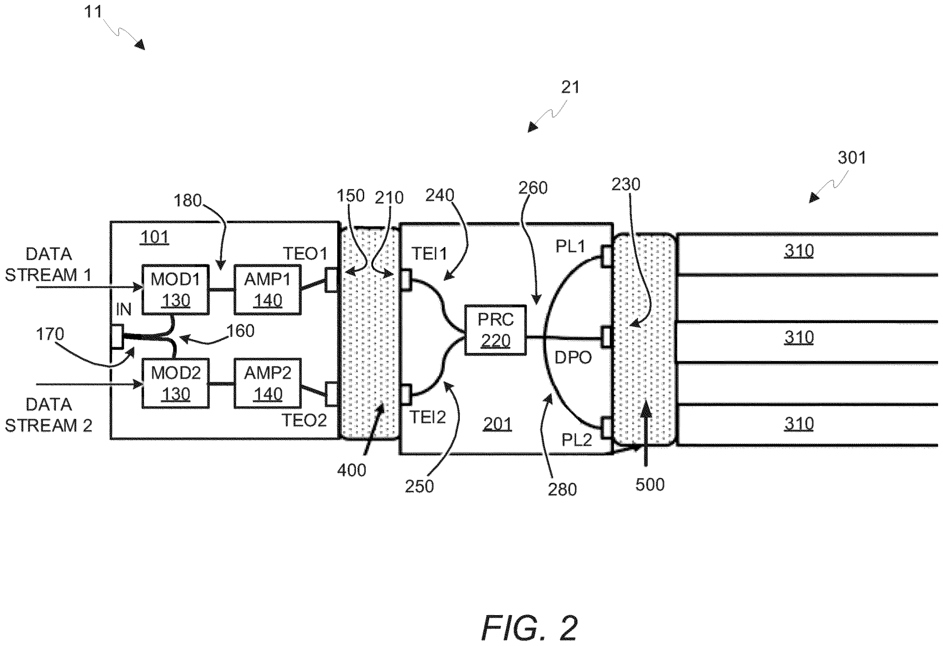

Variations of the optical communication system 10 are depicted in FIGS. 2-5C. In particular, FIG. 2 depicts an optical communication system 11 comprising an optical transmitter 21 coupled to a fiber array 301. Similar to the optical transmitter 20, the optical transmitter 21 may include a first chip 101 and a second chip 201 that is coupled to the fiber array 301. The first chip 101 and the second chip 201 of FIG. 2 may be implemented in a manner similar to the first chip 100 and the second chip 200 of FIG. 1. Like, the first chip 100 of FIG. 1, the first chip 101 comprises optical ports TEO1, TEO2 along a second chip facing side of the first chip 101. However, unlike the first chip 100 of FIG. 1, the first chip 101 comprises a signal input port IN along another side (e.g., side opposite or at a 90° angle to the second chip facing side) of the first chip 101. By positioning the signal input port IN along a side other than the second chip facing side, an unmodulated signal may be supplied directly to the first chip 101 without first passing through the second chip 201. As such, the second chip 201 may be implemented in a manner similar to the second chip 200, but may lack the pass through waveguide 270 and associated optical ports TPI, TPO of the second chip 200. Similarly, the fiber array 301 attached to the second chip 201 may lack the optical fiber 310 of fiber array 300 associated with the optical port TPI of the second chip 200.

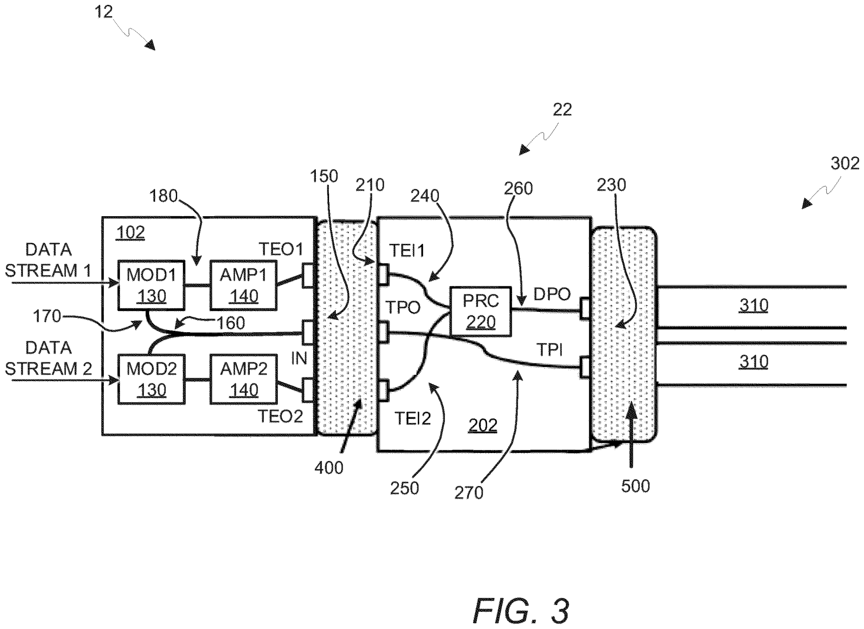

FIG. 3 depicts an optical communication system 12 comprising an optical transmitter 22 coupled to a fiber array 302. Similar to the optical transmitter 20, the optical transmitter 22 may include a first chip 102 and a second chip 202 that is coupled to the fiber array 302. The first chip 102 and the second chip 202 of FIG. 3 may be implemented in a manner similar to the first chip 100 and the second chip 200 of FIG. 1. However, the second chip 202 may lack the passive loop waveguide 280 and associated optical ports PL1, PL2 of the second chip 200. Similarly, the fiber array 302 attached to the second chip 202 may lack the optical fibers 310 of the fiber array 300 associated with the optical ports PL1, PL2 of the second chip 200.

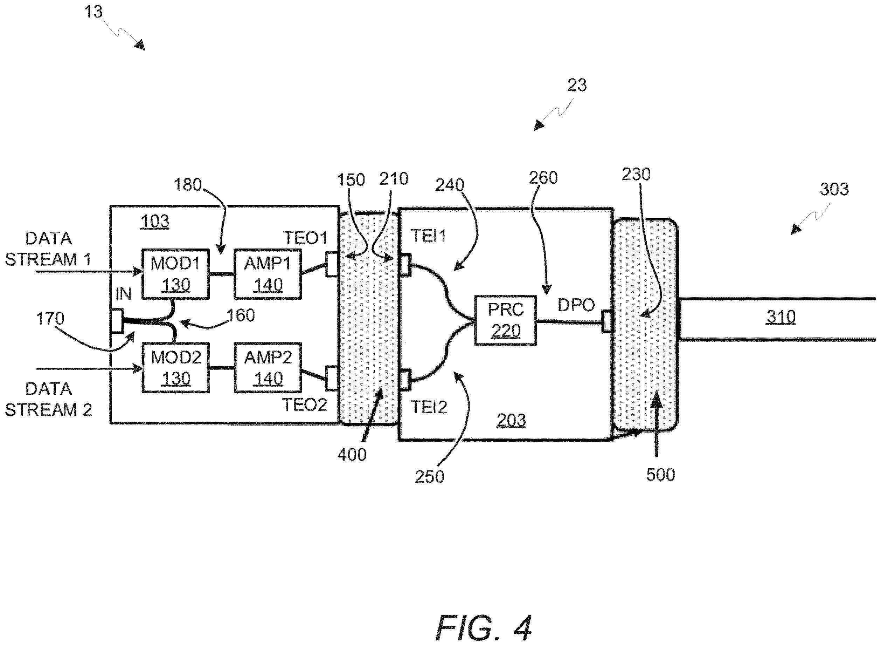

FIG. 4 depicts an optical communication system 13 comprising an optical transmitter 23 coupled to a fiber array 303. Similar to the optical transmitter 20, the optical transmitter 23 may include a first chip 103 and a second chip 203 that is coupled to the fiber array 303. The first chip 103 and the second chip 203 of FIG. 4 may be implemented in a manner similar to the first chip 100 and the second chip 200 of FIG. 1. Like, the first chip 100 of FIG. 1, the first chip 103 may comprise optical ports TEO1, TEO2 along a second chip facing side of the first chip 103. However, unlike the first chip 100 of FIG. 1, the first chip 103 comprises a signal input port IN along another side (e.g., side opposite or at a 90° angle to the second chip facing side) of the first chip 103. By positioning the signal input port IN along a side other than the second chip facing side, an unmodulated signal may be supplied directly to the first chip 103 without first passing through the second chips 203. As such, the second chip 203 may be implemented in a manner similar to the second chip 200, but may lack the pass through waveguide 270 and associated optical ports TPI, TPO of the second chip 200. As such, the fiber array 303 attached to the second chip 203 may lack the optical fiber 310 of fiber array 300 associated with the optical port TPI of the second chip 200.

Further, the second chip 203 may lack the passive loop waveguide 280 and associated optical ports PL1, PL2 of the second chip 200. As such, the fiber array 303 attached to the second chip 203 may lack the optical fibers 310 of fiber array 300 associated with the optical ports PL1, PL2 of the second chip 200.

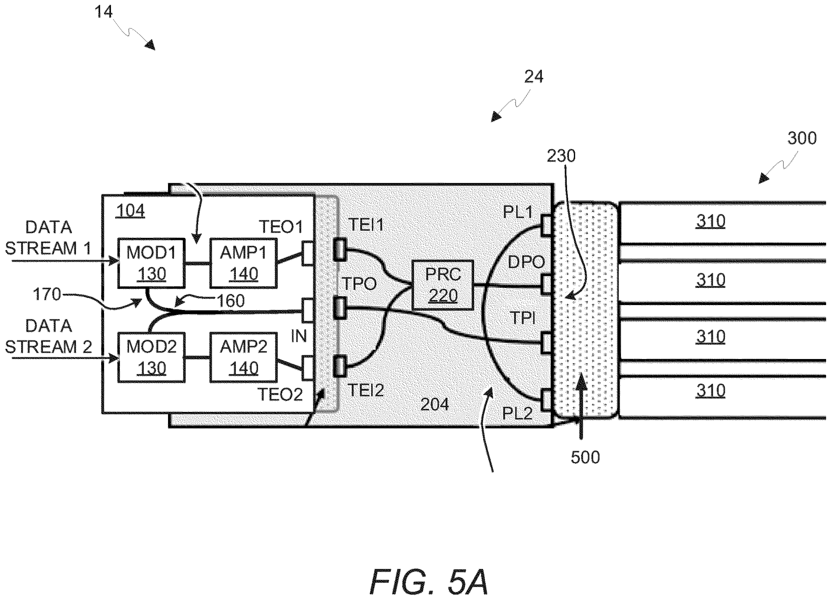

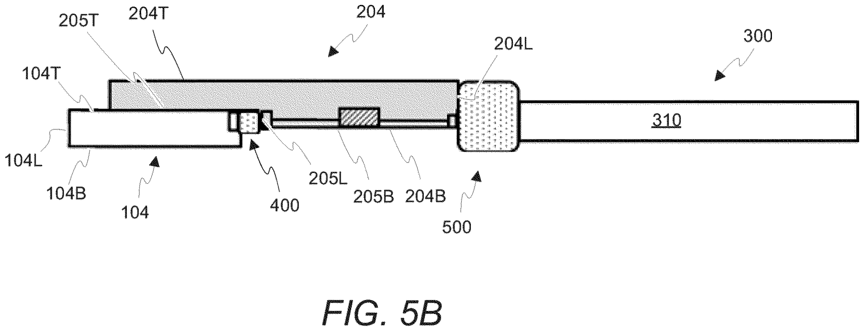

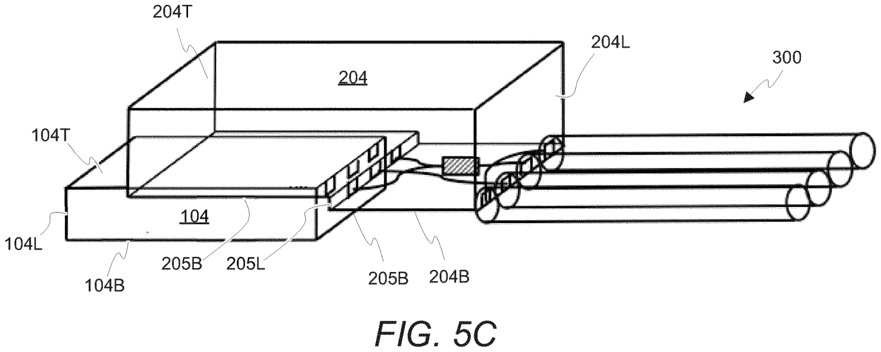

FIGS. 5A-5C depict an optical communication system 14 comprising an optical transmitter 24 coupled to a fiber array 300. Similar to the optical transmitter 20, the optical transmitter 24 may include a first chip 104 and a second chip 204 that is coupled to the fiber array 300. The first chip 104 and the second chip 204 of FIGS. 5A-5C may be implemented in a manner similar to the first chip 100 and the second chip 200 of FIG. 1. However, unlike the optical transmitter 20, the second chip 204 may be stacked upon the first chip 104 or *vice versa.* Such stacking is shown in FIGS. 5A-5C in which FIG. 5A provides a bottom view of the optical communication system 14, FIG. 5B provides a side view of the optical communication system 14, and FIG. 5C provides a diametric view of the optical communication system 14.

As shown, the first chip 104 may comprise a first chip top side 104T, a first chip bottom side 104B opposite the first chip top side 104T, and first chip lateral sides 104L between the first chip top side 104T and the first chip lateral side 104L. Similarly, the second chip 204 may comprise a second chip top side 204T, a second chip bottom side 204B opposite the second chip top side 204T, and second chip lateral sides 204L between the second chip top side 204T and the second chip lateral side 204L.

As best shown in FIG. 5B, the second chip bottom side 204B may be tiered such that a second chip top side 204B comprises a top tier surface 205T, a bottom tier surface 205B, and a lateral surface 205L between the top tier surface 205T and the bottom tier surface 205B. The optical ports 210 (e.g., optical ports TEI1, TEI2, TPO) of the second chip 204 may be positioned along the lateral surface 205L between the top tier surface 205T and the bottom tier surface 205B. As a result of such positioning, the second chip 204 may be positioned over the first chip 104 such that the bottom tier surface 205B of the second chip bottom side 204B rests upon and/or is coupled to the first chip top side 104T. Moreover, such positioning may vertically align the optical ports 150 *(e.g.,* optical ports TEO1, TEO2, IN) of the first chip 104 with the ports 210 of the second chip 204.

FIGS. 5A-5C depict an embodiment in which a surface of the second chip 204 is tiered. However, the optical transmitter 24 may be implemented with a surface of the first chip 104 tiered instead of a surface of the second chip 204. Similarly, in some embodiments, both a surface of the first chip 104 and a surface of the second chip 204 may be tiered.

Further, the optical transmitter 24 of FIGS. 5A-5C generally depicts a stacked implementation of the optical transmitter 20 of FIG. 1. However, the stacked configuration of FIGS. 5A-5C may implement the optical transmitters 21, 22, 23 of FIGS. 2-4.

Moreover, as noted above, the second chip 200 may be part of an optical receiver and may be used to split and rotate a TM polarized signal from a dual polarized signal comprising a TM polarized signal and TE polarized signal. The second chips 201, 202, 203, 204 of FIGS. 2-5C may likewise be a part of an optical receiver and may be used to split and rotate a TM polarized signal from a dual polarized signal comprising a TM polarized signal and TE polarized signal.

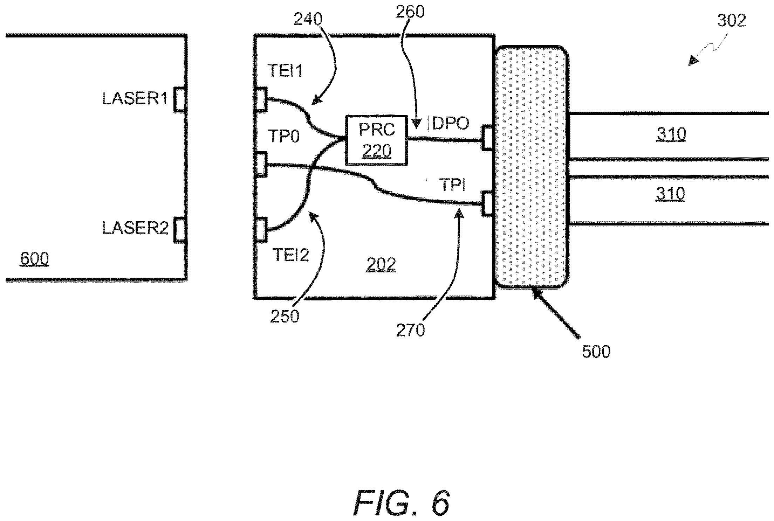

Referring now to FIG. 6, an alignment device 600 is shown which may be used to aid in aligning the optical ports 230 of the second chip 202 of FIG. 3 with the optical fibers 310 of the fiber array 302. The alignment device 600 may also be used to align the fiber array 303 to the multi-polarized signal port DPO of the second chip 203 of FIG. 4. Only second chip 202 of FIG. 3 is depicted. The process is similar for the second chip 203 of FIG. 4.

Since the second chips 202, 203 may lack the passive loop waveguide 280, the alignment process discussed above with regard to the optical transmitter 20 may not be suitable. To align the fiber array 302 to the optical ports 230 of the second chip 202, an alignment device 600 may be coupled to the optical ports 210 of the second chip 202. In particular, the alignment device 600 may comprise two laser outputs LASER1, LASER 2 that align with the optical ports TEI1, TEI2 of the second chip 202. The laser outputs LASER1, LASER2, may inject light into the optical ports TEI1, TEI2. The second chip 202 may guide such light to the multi-polarized signal port DPO. The relative position of the second chip 200 to the fiber array 300 may then be adjusted to maximize a coupling of light applied to the multi-polarized signal port DPO. The optical fiber 310 corresponding to multi-polarized signal port DPO may be coupled to a photodetector or other sensor to monitor the coupling of the light to the multi-polarized signal port DPO. In various embodiments, the spacing of the optical ports 230 of the second chip 202 matches the spacing of the optical fibers 310 of the fiber array 302. Thus, proper alignment of the optical fiber 310 to the multi-polarized signal port DPO via the above alignment process ensures that the optical ports TP1 is also appropriately aligned with correspond optical fibers 310 of the fiber array 300. After proper alignment is achieved, the epoxy 500 may be applied in order to attach and maintain proper alignment between the fiber array 302 to the second chip 202.

After attaching the fiber array 302 to the second chip 202, the alignment device 600 may be removed and the optical ports 150 of the first chip 102 may be aligned and coupled to the optical ports 210 of the second chip 202. Such alignment may be achieved actively based on light exiting the optical ports 150 or passively based on fiducials or through flip-chip bonding techniques. The residual gap between the first chip 102 and the second chip 202 may then be filled with the epoxy 400.

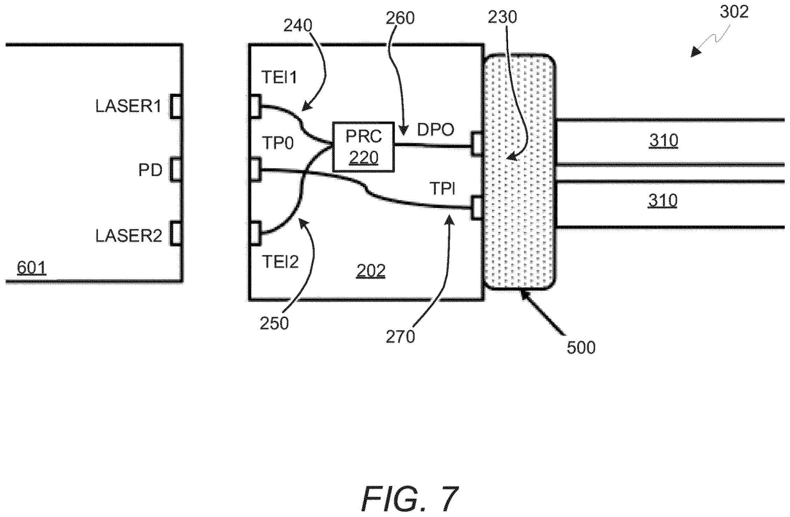

Referring now to FIG. 7, an alignment device 601 is shown which may be used to aid in aligning the optical ports 230 of the second chip 202 with the optical fibers 310 of the fiber array 302. Since the second chip 202 may lack the passive loop waveguide 280, the alignment process discussed above with regard to the optical transmitter 20 may not be suitable.

To align the fiber array 302 to the optical ports 230, an alignment device 601 may be coupled to the optical ports 210 of the second chip 202. In particular, the alignment device 601 may comprise two laser outputs LASER1, LASER 2 that align with the optical ports TEI1, TEI2 of the second chip 202 and an optical port PD coupled to a photodetector of the alignment device 601 of another device. The laser outputs LASER1, LASER2, may inject light into the optical ports TEI1, TEI2. The second chip 202 may guide such light to the multi-polarized signal port DPO. Further, the optical fiber 310 associated with the optical port TPI may inject light into the optical port TPI to be coupled into optical port PD and detected by a photodetector of the alignment device 601 or of another device. Alignment may proceed by first maximizing the coupling through the optical port PD to fix the lateral positioning of the second chip 202 with regard to the fiber array 300. In a subsequent step, rotational positioning of the second chip 202 with regard to the fiber array 300 may involve maximizing a coupling of light applied to the multi-polarized signal port DPO via laser output LASER1, LASER2 by optimizing the rotation of the fiber array 300 around an axis of the optical fiber 310 associated with the optical port TPI. To this end, the optical fiber 310 corresponding to multi-polarized signal port DPO may be coupled to a photodetector or other sensor to monitor the coupling of the light to the multi-polarized signal port DPO. After proper alignment is achieved, the epoxy 500 may be applied in order to attach and maintain proper alignment between the fiber array 302 to the second chip 202.

After attaching the fiber array 302 to the second chip 202, the alignment device 601 may be removed and the optical ports 150 of the first chip 102 may be aligned and coupled to the optical ports 210 of the second chip 202. Such alignment may be achieved actively based on light exiting the optical ports 150 or passively based on fiducials or through flip-chip bonding techniques. The residual gap between the first chip 102 and the second chip 202 may then be filled with the epoxy 400.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. An optical device, comprising:
   a first chip comprising a first polarized signal optical port, a second polarized signal optical port, and one or more optical elements coupled to the first polarized signal optical port and the second polarized signal optical port; and
   a second chip comprising a first polarized signal optical port coupled to the first polarized signal optical port of the first chip, a second polarized signal optical port coupled to the second polarized signal optical port of the first chip, a multi-polarized signal optical port, and a polarization rotating and combining (PRC) element that couples the first polarized signal optical port and the second polarized signal optical port of the second chip to the multi-polarized signal optical port of the second chip;
   wherein the first chip comprises a first semiconductor chip material; and
   wherein the second chip comprises a second semiconductor chip material that is different than the first semiconductor chip material.
2. The optical device of aspect 1, wherein:
   the first semiconductor chip material comprises a III-V semiconductor material; and
   the second semiconductor chip material comprises silicon.
3. The optical device of aspect 2, wherein the III-V semiconductor material comprises Indium Phosphide (InP).
4. The optical device of aspect 2, wherein the III-V semiconductor material comprises Gallium Arsenide (GaAs).
5. The optical device of aspect 1, wherein the one or more optical elements of the first chip comprises one or more modulators configured to:
   provide the first polarized optical signal port of the first chip with a first polarized optical signal having a first polarization; and
   provide the second polarized optical signal port of the first chip with a second polarized optical signal having a second polarization that is the same as the first polarization.
6. The optical device of aspect 5, wherein the PRC element of the second chip is configured to:
   rotate the first polarized optical signal received from the first chip to a third polarized optical signal having a third polarization different than the second polarization of the signal polarized optical signal;
   combine the third polarized optical signal with the second polarized optical signal; and
   provide the combined signal to the multi-polarized signal optical port.
7. The optical device of aspect 1, wherein the one or more optical elements of the first chip comprises one or more modulators configured to:
   provide the first polarized optical signal port of the first chip with a first transverse-electric (TE) polarized signal; and
   provide the second polarized optical signal port of the first chip with a second TE polarized signal.
8. The optical device of aspect 7, wherein the PRC element of the second chip is configured to:
   rotate the first TE polarized signal to a transverse-magnetic (TM) polarized signal;
   combine the TM polarized signal with the second TE polarized signal to obtain a combined signal comprises the TM polarized signal and the second TE polarized signal; and
   provide the combined signal to the multi-polarized signal optical port.
9. The optical device of aspect 1, wherein the PRC element of the second chip is configured to:
   receive a multi-polarized optical signal from the multi-polarization signal optical port of the second chip, wherein the multi-polarized optical signal comprises a first polarized optical signal having a first polarization and a second polarized optical signal having a second polarization, and wherein the first polarization differs from the second polarization;
   rotate the first polarized optical signal to a rotated first polarized optical signal having a third polarization such that the rotated first polarized optical signal and the second polarized optical signal have a same polarization;
   provide the rotated first polarized optical signal to the first chip via the first polarized optical signal port of the second chip; and
   provide the second polarized optical signal to the first chip via the second polarized optical signal port of the second chip.
10. The optical device of aspect 1, wherein the PRC element of the second chip is configured to:
   receive a dual polarized optical signal from the multi-polarized signal optical port of the second chip, wherein the dual polarized optical signal comprises a first transverse-electric (TE) polarized signal and a second transverse-magnetic (TM) polarized signal;
   rotate the second TM polarized signal to a second TE polarized signal;
   provide the first TE polarized signal to the first chip via the first polarized optical signal port of the second chip; and
   provide the second TE polarized signal to the first chip via the second polarized optical signal port of the second chip.
11. The optical device of aspect 1, wherein the second chip comprises:
   a first passive loop optical port;
   a second passive loop optical port; and
   a passive loop waveguide that couples the first passive loop optical port to the second passive loop optical port.
12. The optical device of aspect 1, wherein the second chip comprises:
   a first pass-through optical port along a first lateral side of the second chip;
   a second pass-through optical port along a second lateral side of the second chip; and
   a pass-through waveguide that couples the first pass-through optical port to the second pass-through optical port.
13. The optical device of aspect 1, wherein the first chip comprises an input optical port coupled to the first pass-through optical port of the second chip.
14. The optical device of aspect 13, wherein:
   the first chip and the second chip are part of an optical transmitter; and
   the one or more optical elements of the first chip comprises one or more modulators configured to modulate an unmodulated signal received via the input optical port of the first chip and the first pass-through optical port of the second chip.
15. The optical device of aspect 13, wherein:
   the first chip and the second chip are part of an optical receiver; and
   the one or more optical elements of the first chip comprises one or more balanced receiver pairs configured for coherent reception using a local oscillator signal received via the input optical port of the first chip and the first pass-through optical port of the second chip.
16. The optical device of aspect 1, comprising a fiber array of one or more optical fibers coupled to the second chip.
17. The optical device of aspect 16, comprising an epoxy that attaches the fiber array to the second chip, wherein the epoxy has a refractive index that matches a refractive index of the second chip.
18. The optical device of aspect 1, comprising an epoxy that attaches first chip to the second chip, wherein the epoxy has a refractive index that matches a refractive index of the second chip.
19. The optical device of aspect 18, wherein one or more facets of the first polarized optical signal port and the second polarized optical signal port are coated with an antireflective coating having a refractive index that matches the epoxy.
20. The optical device of aspect 1, wherein:
   the first chip is stacked upon the second chip; and
   the first chip and/or the second chip positions their respective chip-facing optical ports along a lateral surface between tiered surfaces of the respective first chip and/or the second chip.

Implementations as described herein may relate to the following: An optical device includes a first chip and a second chip. The first chip includes a first polarized signal optical port, a second polarized signal optical port, and one or more optical elements coupled to the first polarized signal optical port and the second polarized signal optical port. The second chip includes a first polarized signal optical port coupled to the first polarized signal optical port of the first chip, a second polarized signal optical port coupled to the second polarized signal optical port of the first chip, a multi-polarized signal optical port, and a polarization rotating and combining element that couples the first polarized signal optical port and the second polarized optical port to the multi-polarized signal optical port. The first chip comprises a first semiconductor chip material. The second chip comprises a second semiconductor chip material that is different than the first semiconductor chip material.

The present application claims priority of U.S. Patent Application No. 18/599,506, filed March 8, 2024. The entire disclosure of this application is hereby explicitly incorporated by reference into the present application.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will include all examples falling within the scope of the appended claims.

## Claims

1. An optical device, comprising:
a first chip comprising a first polarized signal optical port, a second polarized signal optical port, and one or more optical elements coupled to the first polarized signal optical port and the second polarized signal optical port; and
a second chip comprising a first polarized signal optical port coupled to the first polarized signal optical port of the first chip, a second polarized signal optical port coupled to the second polarized signal optical port of the first chip, a multi-polarized signal optical port, and a polarization rotating and combining (PRC) element that couples the first polarized signal optical port and the second polarized signal optical port of the second chip to the multi-polarized signal optical port of the second chip;
wherein the first chip comprises a first semiconductor chip material; and
wherein the second chip comprises a second semiconductor chip material that is different than the first semiconductor chip material.

2. The optical device of claim 1, wherein:
the first semiconductor chip material comprises a III-V semiconductor material; and
the second semiconductor chip material comprises silicon.

3. The optical device of claim 2, wherein the III-V semiconductor material comprises
a) Indium Phosphide (InP) and/or
b) Gallium Arsenide (GaAs).

4. The optical device of any one of claims 1 to 3, wherein the one or more optical elements of the first chip comprises one or more modulators configured to:
provide the first polarized optical signal port of the first chip with a first polarized optical signal having a first polarization; and
provide the second polarized optical signal port of the first chip with a second polarized optical signal having a second polarization that is the same as the first polarization, and, optionally, wherein the PRC element of the second chip is configured to:
rotate the first polarized optical signal received from the first chip to a third polarized optical signal having a third polarization different than the second polarization of the signal polarized optical signal;
combine the third polarized optical signal with the second polarized optical signal; and
provide the combined signal to the multi-polarized signal optical port.

5. The optical device of any one of claims 1 to 4, wherein the one or more optical elements of the first chip comprises one or more modulators configured to:
provide the first polarized optical signal port of the first chip with a first transverse-electric (TE) polarized signal; and
provide the second polarized optical signal port of the first chip with a second TE polarized signal, and, optionally, wherein the PRC element of the second chip is configured to:
rotate the first TE polarized signal to a transverse-magnetic (TM) polarized signal;
combine the TM polarized signal with the second TE polarized signal to obtain a combined signal comprises the TM polarized signal and the second TE polarized signal; and
provide the combined signal to the multi-polarized signal optical port.

6. The optical device of any one of claims 1 to 5, wherein the PRC element of the second chip is configured to:
receive a multi-polarized optical signal from the multi-polarization signal optical port of the second chip, wherein the multi-polarized optical signal comprises a first polarized optical signal having a first polarization and a second polarized optical signal having a second polarization, and wherein the first polarization differs from the second polarization;
rotate the first polarized optical signal to a rotated first polarized optical signal having a third polarization such that the rotated first polarized optical signal and the second polarized optical signal have a same polarization;
provide the rotated first polarized optical signal to the first chip via the first polarized optical signal port of the second chip; and
provide the second polarized optical signal to the first chip via the second polarized optical signal port of the second chip.

7. The optical device of any one of claims 1 to 6, wherein the PRC element of the second chip is configured to:
receive a dual polarized optical signal from the multi-polarized signal optical port of the second chip, wherein the dual polarized optical signal comprises a first transverse-electric (TE) polarized signal and a second transverse-magnetic (TM) polarized signal;
rotate the second TM polarized signal to a second TE polarized signal;
provide the first TE polarized signal to the first chip via the first polarized optical signal port of the second chip; and
provide the second TE polarized signal to the first chip via the second polarized optical signal port of the second chip.

8. The optical device of any one of claims 1 to 7, wherein the second chip comprises:
a first passive loop optical port;
a second passive loop optical port; and
a passive loop waveguide that couples the first passive loop optical port to the second passive loop optical port.

9. The optical device of any one of claims 1 to 8, wherein the second chip comprises:
a first pass-through optical port along a first lateral side of the second chip;
a second pass-through optical port along a second lateral side of the second chip; and
a pass-through waveguide that couples the first pass-through optical port to the second pass-through optical port.

10. The optical device of any one of claims 1 to 9, wherein the first chip comprises an input optical port coupled to the first pass-through optical port of the second chip.

11. The optical device of claim 10, wherein:
the first chip and the second chip are part of an optical transmitter; and
the one or more optical elements of the first chip comprises one or more modulators configured to modulate an unmodulated signal received via the input optical port of the first chip and the first pass-through optical port of the second chip.

12. The optical device of claim 10, wherein:
the first chip and the second chip are part of an optical receiver; and
the one or more optical elements of the first chip comprises one or more balanced receiver pairs configured for coherent reception using a local oscillator signal received via the input optical port of the first chip and the first pass-through optical port of the second chip.

13. The optical device of any one of claims 1 to 12, comprising a fiber array of one or more optical fibers coupled to the second chip, and, optionally, comprising an epoxy that attaches the fiber array to the second chip, wherein the epoxy has a refractive index that matches a refractive index of the second chip.

14. The optical device of any one of claims 1 to 13, comprising an epoxy that attaches the first chip to the second chip, wherein the epoxy has a refractive index that matches a refractive index of the second chip, and, optionally, wherein one or more facets of the first polarized optical signal port and the second polarized optical signal port are coated with an antireflective coating having a refractive index that matches the epoxy.

15. The optical device of any one of claims 1 to 14, wherein:
the first chip is stacked upon the second chip; and
the first chip and/or the second chip positions their respective chip-facing optical ports along a lateral surface between tiered surfaces of the respective first chip and/or the second chip.
